# EUROPEAN PATENT APPLICATION

(11) **EP 1 898 457 A1**
(43) Date of publication of application: **12.03.2008**
(21) Application number: 07015109.7
(22) Date of filing: 01.08.2007
(51) Int. Cl.: H01L 21/683, H02N 13/00

(54) **Substrate support with a protective layer for plasma resistance**

(30) Priority: 01.08.2006 US 461643
(71) Applicant: Applied Materials, Inc., Santa Clara, CA 95054 (US)
(72) Inventor: Sun, Jennifer Y., Sunnyvale, CA 94086 (US); Chou, Irene A., San Jose, CA 95129 (US)
(74) Representative: Zimmermann, Gerd Heinrich

(57) **Abstract**

Embodiments of the present invention provide a substrate support assembly (148) having a protective layer (136) that enhances plasma resistance. In one embodiment, a substrate support assembly includes an electrostatic chuck (150) having an upper substrate support surface, and a protective layer disposed on the electrostatic chuck, wherein the protective layer is fabricated by a ceramic material containing a rare earth metal.

## Description

Embodiments of the invention generally relate to a semiconductor processing chamber, more specifically, for a substrate support having a protective layer suitable for use in a semiconductor processing chamber.

Semiconductor processing involves a number of different chemical and physical processes whereby minute integrated circuits are created on a substrate. Layers of materials which make up the integrated circuit are created by chemical vapor deposition, physical vapor deposition, epitaxial growth, and the like. Some of the layers of material are patterned using photoresist masks and wet or dry etching techniques. The substrate utilized to form integrated circuits may be silicon, gallium arsenide, indium phosphide, glass, or other appropriate material.

A typical semiconductor processing chamber includes a chamber body defining a process zone, a gas distribution assembly adapted to supply a gas from a gas supply into the process zone, a gas energizer, e.g., a plasma generator, utilized to energize the process gas to process a substrate positioned on a substrate support assembly, and a gas exhaust. The substrate support assembly may include an electrostatic chuck that holds the substrate to the substrate support assembly during processing. During plasma processing, the energized gas is often comprised of highly corrosive species which etches and erodes exposed portions of the substrate support assembly. The eroded support substrate assembly must be replaced after a number of process cycles and before it provides inconsistent or undesirable electrical properties for holding substrates. Additionally, particles eroded from the substrate support assembly may contaminate substrates being held on the substrate support assembly, thereby resulting in processing defects. It would be desirable to have a substrate support assembly having greater plasma resistance to increase the service life of the substrate support assembly and reduce particle generation.

Therefore, there is a need for a coating that provides increase plasma resistance for chamber components, such as a substrate support assembly.
In light of the above, the substrate support assembly according to independent claims 1, 18, and 25 are provided.
Further advantages, features, aspects and details of the invention are evident from the dependent claims, the description and the drawings.

Embodiments of the present invention provide a substrate support assembly having a protective layer that enhances plasma resistance. The protective layer provides a robust corrosion and plasma resisting surface on the substrate support assembly, thereby improving the service life of the substrate support assembly while reducing maintenance and manufacturing cost.

In one embodiment, a substrate support assembly includes an electrostatic chuck having an upper substrate support surface, a protective layer disposed on the electrostatic chuck, wherein the protective layer includes a ceramic material containing a rare earth metal.

In another embodiment, a substrate support assembly includes an electrostatic chuck including an ceramic puck having an upper surface adapted to support a substrate disposed thereon, a base attached to a lower surface of the ceramic puck, the base having at least one fluid conduit formed therein and adapted to control the lateral temperature profile of the electrostatic puck; and a protective layer disposed on the ceramic puck, wherein the protective coating is a ceramic material containing a rare earth metal.

In yet another embodiment, a substrate support assembly includes a ceramic puck, a base attached to a lower surface of the ceramic puck, the base having at least one fluid conduit formed therein and adapted to control the lateral temperature profile of the ceramic puck, an adhesive coupling the base to a lower surface of the puck, metal fillers disposed in the adhesive, the metal fillers comprising at least one of Al, Mg, Ta, Ti, and a protective Y₂O₃ coating coated on the upper surface of the ceramic puck.

So that the manner in which the above recited features of the present invention can be understood in detail, a more particular description of the invention, briefly summarized above, may be had by reference to embodiments, some of which are illustrated in the appended drawings.

Figure 1 depicts a sectional view of one embodiment of a processing chamber;

Figure 2 depicts a exploded view of one embodiment of a substrate support assembly according the present invention; and

Figure 3 depicts a top view of one embodiment of an electrostatic chuck of the substrate support assembly of Figure 2.

It is to be noted, however, that the appended drawings illustrate only typical embodiments of this invention and are therefore not to be considered limiting of its scope, for the invention may admit to other equally effective embodiments.

To facilitate understanding, identical reference numerals have been used, wherever possible, to designate identical elements that are common to the figures. It is contemplated that elements of one embodiment may be advantageously utilized in other embodiments without further recitation.

Embodiments of the present invention provide a substrate support assembly having a protective layer utilized to enhance plasma corrosion resistance. In one embodiment, the protective layer may be a ceramic layer including a rare earth metal. Examples of the protective layer may include yttrium (Y), yttrium oxide (Y₂O₃), yttrium alloy or deviations thereof. The protective coating layer provides a corrosion resistance surface on the substrate support assembly, thereby improving the service life of the substrate support assembly, while reducing maintenance and manufacturing cost.

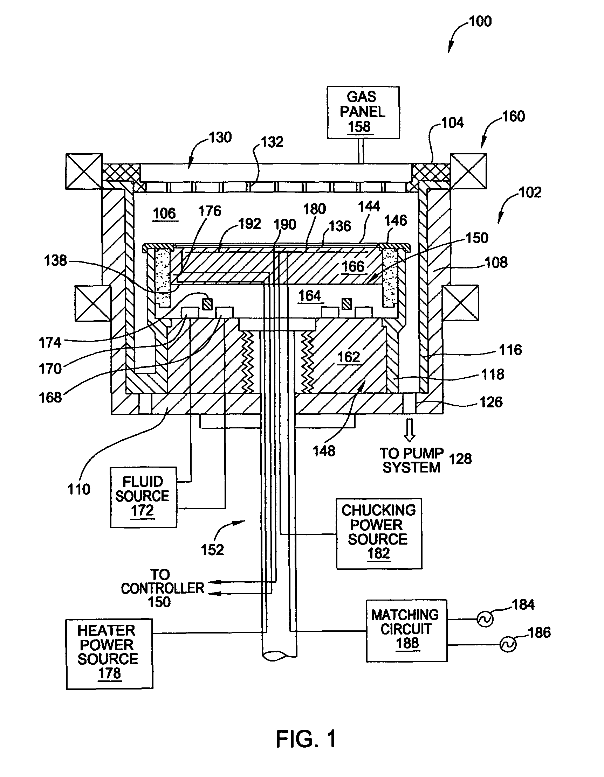

Figure 1 is a sectional view of one embodiment of a semiconductor processing chamber 100 having a substrate support assembly 148 disposed therein having a protective layer 136. Although one embodiment of a substrate support assembly 148 is disposed herein, it is contemplated that other substrate support assemblies may be adapted to benefit from the invention.

The processing chamber 100 includes a chamber body 102 and a lid 104 that enclose an interior volume 106. The chamber body 102 is typically fabricated from aluminum, stainless steel or other suitable material. The chamber body 102 generally includes sidewalls 108 and a bottom 110. A substrate access port (not shown) is generally defined in a side wall 108 and a selectively sealed by a slit valve to facilitate entry and egress of a substrate 144 from the processing chamber 100.

An outer liner 116 may be disposed adjacent the side walls 108 to protect the chamber body 102. The outer liner 116 may be fabricated and/or coated with a plasma or halogen-containing gas resistant material. In one embodiment, the outer liner 116 is fabricated from aluminum oxide. In another embodiment, the outer liner 116 is fabricated from or coated with yttrium, yttrium alloy or an oxide thereof. In yet another embodiment, the outer liner 116 is fabricated from bulk Y₂O₃.

An exhaust port 126 is defined in the chamber body 102 and couples the interior volume 106 to a pump system 128. The pump system 128 generally includes one or more pumps and throttle valves utilized to evacuate and regulate the pressure of the interior volume 106 of the processing chamber 100. In one embodiment, the pump system 128 maintains the pressure inside the interior volume 106 at operating pressures typically between about 10 mTorr to about 20 Torr.

The lid 104 is sealingly supported on the sidewall 108 of the chamber body 102. The lid 104 may be opened to allow excess to the interior volume 106 of the processing chamber 100. A gas panel 158 is coupled to the processing chamber 100 to provide process and/or cleaning gases to the interior volume 106 through a gas distribution assembly 130. Examples of processing gases may be used to process in the processing chamber including halogen-containing gas, such as C₂F₆, SF₆, SiCl₄, HBr, NF₃, CF₄, CHF₃, CH₂F₃, Cl₂ and SiF₄, among others, and other gases such as O₂, or N₂O. Examples of carrier gases include N₂, He, Ar, other gases inert to the process and nonreactive gases. The gas distribution assembly 130 may having a plurality of apertures 132 on the downstream surface of the gas distribution assembly 130 to direct the gas flow to the surface of the substrate 144. The gas distribution assembly 130 may be fabricated and/or coated by a ceramic material, such as silicon carbide, bulk Yttrium or oxide thereof to provide resistance to halogen-containing chemistries to prevent the gas distribution assembly 130 from corrosion.

The substrate support assembly 148 is disposed in the interior volume 106 of the processing chamber 100 below the gas distribution assembly 130. The substrate support assembly 148 holds the substrate 144 during processing. The substrate support assembly 148 generally includes a plurality of lift pins (not shown) disposed therethrough that are configured to lift the substrate 144 from the support assembly 148 and facilitate exchange of the substrate 144 with a robot (not shown) in a conventional manner.

An inner liner 118 may be coated on the periphery of the substrate support assembly 148. The inner liner 118 may be a halogen-containing gas resist material which is substantially similar material as the outer liner 116. In one embodiment, the inner liner 118 may be fabricated from the same materials of the outer liner 116.

In one embodiment, the substrate support assembly 148 includes a mounting plate 162 supporting a pedestal 152, and an electrostatic chuck 150. The electrostatic chuck 150 further includes a base 164 and an electrostatic puck 166. The upper support surface of the electrostatic puck 166 is covered by a protecting layer 136. In one embodiment, the protecting layer 136 may be disposed on the upper support surface of the electrostatic puck 166. In another embodiment, the protecting layer 136 may be disposed on the entire surface of the electrostatic chuck 150 including the outer and side periphery of the base 164 and the electrostatic puck 166. The mounting plate 162 is coupled to the bottom 110 of the chamber body 102 includes passages for routing utilities, such as fluids, power lines and sensor leads, among other, to the base 164 and the electrostatic puck 166.

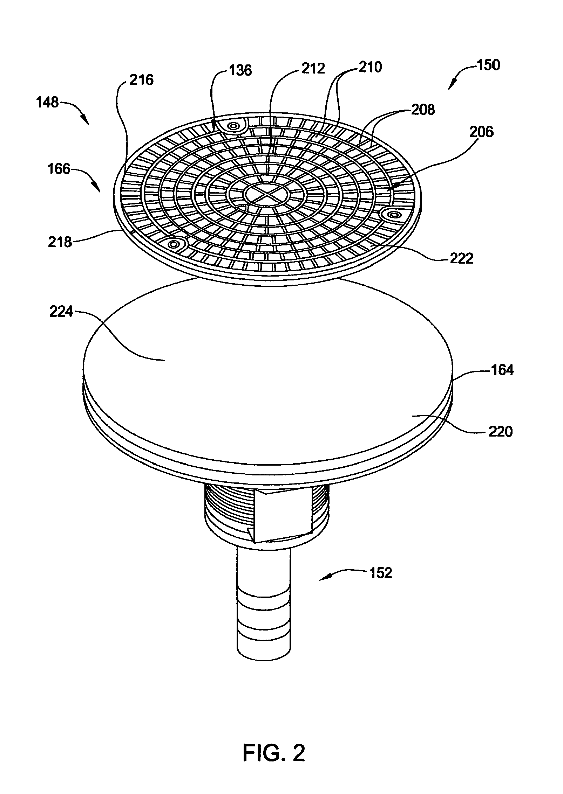

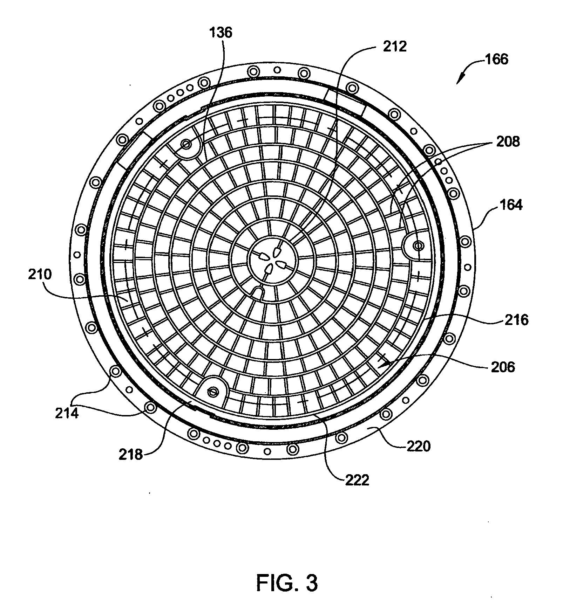

At least one of the base 164 or puck 166 may include at least one optional embedded heater 176, at least one optional embedded isolator 174 and a plurality of conduits 168, 170 to control the lateral temperature profile of the support assembly 148. The conduits 168, 170 are fluidly coupled to a fluid source 172 that circulates a temperature regulating fluid therethrough. The embedded isolator 174 is disposed between the conduits 168, 170. The heater 176 is regulated by a power source 178. The conduits 168, 170 and heater 176 are utilized to control the temperature of the base 164, thereby heating and/or cooling the electrostatic puck 166. The temperature of the electrostatic puck 166 and the base 164 may be monitored using a plurality of temperature sensors 190, 192. The electrostatic puck 166 may further comprise a plurality of gas passages 208 (shown in Figures 2 and 3), such as grooves, that are formed in a frontside surface 206 of the puck 166 and fluidly coupled to a source of a heat transfer (or backside) gas, such as He. In operation, the backside gas is provided at controlled pressure into the gas passages to enhance the heat transfer between the electrostatic puck 166 and the substrate 144.

The electrostatic puck 166 comprises at least one clamping electrode 180 controlled by a chucking power source 182 positioned external to the chamber 100. The electrode 180 (or other electrode disposed in the puck 166 or base 164) may further be coupled to one or more RF power sources 184, 186 through a matching circuit 188 for maintaining a plasma formed from process and/or other gases within the processing chamber 100. The sources 184, 186 are generally capable of producing RF signal having a frequency from about 50 kHz to about 3 GHz and a power of up to about 10,000 Watts.

Figure 2 depicts an exploded view of one embodiment of the substrate support assembly 148. The substrate support assembly 148 depicts an exploded view of the electrostatic chuck 150 and the pedestal 152. The electrostatic chuck 150 includes the electrostatic puck 166 and the base 164 attached to the electrostatic puck 166. The electrostatic puck 166 has a disc-like shape having an annular periphery 222 that substantially matches the shape and size of the substrate 144 positioned thereon. In one embodiment, the electrostatic puck 166 may be fabricated by a ceramic material. Suitable examples of the ceramic materials include aluminum oxide (Al₂O₃), aluminum nitride (AIN), titanium oxide (TiO), titanium nitride (TiN), silicon carbide (SiC) and the like. In another embodiment, the electrostatic puck 166 may be fabricated by a ceramic material containing rare earth metal according to the present invention. In yet another embodiment, the electrostatic puck 166 may be fabricated by Y₂O₃.

The base 164 attached below the electrostatic puck 166 has a disc-like main portion 224 and an annular flange 220 extending outwardly from a main portion 224 and positioned on the pedestal 152. The base 164 may be fabricated by a material having thermal properties substantially matching that of the overlying puck 166. In one embodiment, the base 164 may be fabricated by a metal, such as aluminum or stainless steel or other suitable materials. Alternatively, the base 164 may be fabricated may be fabricated by a composite of ceramic and metal material providing good strength and durability as well as heat transfer properties. The composite material has a thermal expansion coefficient that is substantially matched to the overlying puck 166 to reduce thermal expansion mismatch. In another embodiment, the base 164 may be fabricated by a composite material includes a ceramic having pores that are infiltrated with a metal, which at least partially fills the ports to from a composite material. The ceramic material may include, but not limited to, silicon carbide, aluminum nitride, aluminum oxide, or cordierite. The ceramic may comprise a pore volume of from about 20 to about 80 volume percent of the total volume, the remainder volume being of the infiltrated metal. The infiltrated metal can comprises aluminum with added silicon and copper. In yet another embodiment, the base 164 may be fabricated by a composite material includes a different composition of a ceramic and metal, such as metal having dispersed ceramic particles.

Referring back to Figure 1, the base 164 is coupled to the electrostatic puck 166 by a bonding material 138. The bonding material 138 facilitates thermal energy exchange between the electrostatic puck 166 and the base 164 and reduces the thermal expansion mismatch therebetween. In one exemplary embodiment, the bonding material 138 mechanically bonds the base 164 to the electrostatic puck 166. In another embodiment, the bonding material 138 may be a thermal conductive paste or tape having at least one of an acrylic based compound and silicon based compound. In yet another embodiment, the bonding material 138 may a thermal conductive paste or tape having at least one of an acrylic based compound and silicon based compound with metal or ceramic fillers mixed or added thereto. The metal filler may be at least one of Al, Mg, Ta, Ti, or combination thereof and the ceramic filler may be at least one of aluminum oxide (Al₂O₃), aluminum nitride (AlN), titanium diboride (TiB₂) or combination thereof. Upon exposure to plasma formed from halogen containing gases, the bonding material 138 may form a self-protective metal halide coating on the surface of the bonding material 138 to prevent the protective layer 138 from further attack. The metal halide coating is generally resistant to further attack from the plasma, and is self-regenerating, if damaged, upon re-exposure to the plasma.

The protective layer 136 is placed and/or coated and/or deposited at least on the upper surface of the electrostatic puck 166 (and/or outer region of the base 164 which may be exposed to plasma during processing) to provide a corrosion resistant coating that may be utilized to protect the exposed surfaces of the puck 166 from the plasma and/or process gases. The protective layer 136 may be coated and/or placed and/or deposited extending to the outer periphery 222 of the base 164, as shown in Figure 2. Alternatively, the protective layer 136 may be coated and/or placed and/or deposited on the entire outer surface of the electrostatic puck 166 and the base 164.

The protective layer 136 may be coated by physical vapor deposition (PVD), chemical vapor deposition (CVD), immersion coating, sputtering, thermal spraying coating (e.g., plasma spraying coating), non-plasma, non-thermal assisted coating, hot isostatic pressing, cold isostatic pressing, lamination, compression molding, casting, compacting, sintering or co-sintering techniques known in the art. In the embodiment depicted in Figure 2-3, the protective layer 136 is coated by physical vapor deposition (PVD).

In one embodiment, the protective layer 136 is a rare earth ceramic layer that includes a Group IIIB metal. The Group IIIB metal may be at least one of scandium (Sc), yttrium (Y), cerium (Ce), or the like. In another embodiment, the protective layer 136 may include an oxide of Group IIIB metal, such as Y₂O₃, or an alloy of Group IIIB metal, such as yttrium-aluminum-garnet (YAG). In yet another embodiment, the protective layer 136 may be a bulk yttrium layer.

In other embodiments, the protective layer 136 may include Y₂O₃ mixed in a metal. Some metals include aluminum (Al), magnesium (Mg), titanium (Ti), tantalum (Ta), and the like. In further embodiments, the protective layer 136 may include doped Y₂O₃. In yet another embodiment, the protective layer 136 may be made by a solid salutation comprising yttrium (Y).

In an alternative embodiment, the electrostatic puck 166 may be fabricated a rare earth ceramic layer, as the protective layer 136 as stated above. In embodiment that the electrostatic puck 166 is fabricated by the rare earth ceramic layer, the protective layer 136 may be alternatively excluded.

In one embodiment, a yttrium oxide layer (Y₂O₃) used for the protective layer 136 or for manufacturing the electrostatic puck 166 is of a high purity to minimize chamber contamination by impurities present in the yttrium oxide layer (Y₂O₃), thereby avoiding potential particulate release into the processing chamber 100 during plasma processing. In one embodiment, yttrium oxide layer (Y₂O₃) has a purity at least about 99.9 percent by volume yttrium oxide and a density of at least about 4.3 g/cm³.

The yttrium oxide layer (Y₂O₃) also has a high hardness that resists corrosion and/or erosion during the plasma processing. In one embodiment, the yttrium oxide layer (Y₂O₃) provides a hardness (Vicker 5 Kgf) between about 3 GPa and about 11 GPa. Additionally, the yttrium oxide layer (Y₂O₃) has a surface roughness between about 2 µ-inch and 400 µ-inch, such as about 16 µ-inch, and water absorbency of about less than 0.02 percent of less.

In one embodiment, the thickness of the yttrium oxide layer (Y₂O₃) protective layer 136 disposed on the substrate support surface is between about 1 µm and about 500 µm, such as about 2 µm and about 30 µm. The average crystalline grain size of the yttrium oxide protective layer 136 is between about 0.01 µm and about 300 µm.

The yttrium oxide (Y₂O₃) protective layer 136 coated on the electrostatic puck 166 forms a strong bonding interface, thereby promoting the adhesion between the electrostatic puck 166 and the coated protective layer 136. The energy dispersive spectrometry (EDS) analysis depicts that the coated yttrium oxide (Y₂O₃) protective layer 136 provides a bonding interfacial layer, such as yttrium containing aluminum oxide, on the electrostatic puck 166 in the embodiments where the dielectric layer 204 is fabricated by aluminum oxide (Al₂O₃). The strong adhesion between the coated yttrium oxide (Y₂O₃) protective layer 136 and the electrostatic puck surface allows the coated yttrium oxide (Y₂O₃) protective layer 136 adhered on the substrate support assembly 148 securely and prevents the yttrium oxide (Y₂O₃) protective layer 136 from cracking, peeling off, or stripping off during plasma processing.

Figure 3 depicts a top view of the electrostatic puck 166. The electrostatic puck 166 includes the frontside surface 206 adapted to receive the substrate 144 on the electrostatic chuck 150. In one embodiment, the frontside surface 206 includes a plurality of raised wedge shaped mesas 210 defined by the interesting gas grooves 208. The gas grooves 208 distribute the heat transfer gas, such as He, on the surface 206, as discussed above. The gas grooves 208 include radial channels that have about 5 degrees to about 10 degrees spacing and terminate in an inner circular groove 212.

Thus, a protective layer used to enhance corrosion resistance on a substrate support assembly is provided in the present invention. The coated protective layer advantageously provides corrosion resist surface on the substrate support assembly, thereby preventing the surface from corrosive environment and increasing the chamber components/parts life time.

While the foregoing is directed to embodiments of the present invention, other and further embodiments of the invention may be devised without departing from the basic scope thereof, and the scope thereof is determined by the claims that follow.

## Claims

1. A substrate support assembly (148), comprising:
an electrostatic chuck (150) having an upper substrate support surface;
a protective layer (136) disposed on the electrostatic chuck, wherein the protective layer includes a ceramic material containing a rare earth metal.

2. The substrate support assembly of claim 1, wherein the protective layer comprises yttrium.

3. The substrate support assembly of any of claims 1 to 2, wherein the protective layer comprises Y₂O₃.

4. The substrate support assembly of any of claims 1 to 3, wherein the rare earth metal further comprises at least one of scandium (Sc) or cerium (Ce).

5. The substrate support assembly of any of claims 1 to 4, wherein the rare earth metal further comprises an oxide of rare earth metal.

6. The substrate support assembly of any of claims 1 to 5, wherein the protective layer (136) comprises yttrium-aluminum-garnet (YAG).

7. The substrate support assembly of any of claims 1 to 6, wherein the protective layer comprises a bulk yttrium layer.

8. The substrate support assembly of any of claims 1 to 7, wherein the protective layer comprises Y₂O₃ mixed in a metal.

9. The substrate support assembly of claim 8, wherein the metal having Y₂O₃ mixed therein is at least one of aluminum (Al), magnesium (Mg), titanium (Ti), tantalum (Ta).

10. The substrate support assembly of any of claims 1 to 9, wherein the protective layer (136) comprises doped Y₂O₃.

11. The substrate support assembly of any of claim 1 to 10, wherein the substrate support assembly further comprises:
a base (164) having at least one cooling channel disposed therein; and
a metal containing adhesive coupling the base to a lower surface of an ceramic puck (166) in the electrostatic chuck (150).

12. The substrate support assembly of claim 11, wherein the ceramic puck is fabricated by at least one of aluminum oxide (Al₂O₃), aluminum nitride (AIN), titanium oxide (TiO), titanium nitride (TiN), silicon carbide (SiC), and a ceramic material containing rare earth metal.

13. The substrate support assembly of claim 12, wherein the rare earth metal of the ceramic material utilized for ceramic puck is Y₂O₃.

14. The substrate support assembly of any of claims 1 to 13, wherein the protective layer (136) has a thickness between about 1 µm and about 500 µm.

15. The substrate support assembly of any of claims 1 to 14, wherein the protective layer has a density greater than about 4.3.

16. The substrate support assembly of any of claim 1 to 15, wherein the protective layer is a ceramic material having a surface roughness between about 2 µ-inch and 400 µ-inch, such as about 16 µ-inch.

17. The substrate support assembly of claim 1, wherein the protective layer is a yttrium oxide layer (Y₂O₃) having a purity at least about 99.9 percent by volume.

18. A substrate support assembly (148), comprising:
an electrostatic chuck (150) including a ceramic puck (166) having an upper surface adapted to support a substrate disposed thereon;
a base (164) attached to a lower surface of the ceramic puck, the base having at least one fluid conduit formed therein and adapted to control the lateral temperature profile of the electrostatic puck; and
a protective layer (136) disposed on the ceramic puck, wherein the protective coating is a ceramic material containing a rare earth metal.

19. The substrate support assembly of claim 18, wherein the protective layer comprises at least one of yttrium, Y₂O₃ or yttrium-aluminum-garnet (YAG).

20. The substrate support assembly of any of claims 18 to 19, wherein the rare earth metal further comprises at least one of scandium (Sc) or cerium (Ce).

21. The substrate support assembly of any of claims 18 to 20, wherein the rare earth metal further comprises an oxide of rare earth metal.

22. The substrate support assembly of any of claims 18 to 21, wherein the protective layer comprises Y₂O₃ mixed in a metal, wherein the metal is at least one of aluminum (Al), magnesium (Mg), titanium (Ti), tantalum (Ta).

23. The substrate support assembly of any of claims 18 to 22, wherein the ceramic puck (166) is fabricated by at least one of aluminum oxide (Al₂O₃), aluminum nitride (AIN), titanium oxide (TiO), titanium nitride (TiN), silicon carbide (SiC), and a ceramic material containing rare earth metal.

24. The substrate support assembly of any of claim 18 to 23, further comprising:
a bonding material coupling the ceramic puck to the base (164), wherein the bonding material is at least one of an acrylic based compound and silicon based compound.

25. A substrate support assembly (148), comprising:
a ceramic puck (166);
a base (164) attached to a lower surface of the ceramic puck, the base having at least one fluid conduit formed therein and adapted to control the lateral temperature profile of the ceramic puck;
an adhesive coupling the base to a lower surface of the puck;
metal fillers disposed in the adhesive, the metal fillers comprising at least one of Al, Mg, Ta, Ti; and
a protective Y₂O₃ coating coated on the upper surface of the ceramic puck.

26. The substrate support assembly of claim 25, wherein the protective Y₂O₃ coating is intermixed with has a metal, wherein the metal is at least one of aluminum (Al), magnesium (Mg), titanium (Ti), tantalum (Ta).

27. The substrate support assembly of any of claims 25 to 26, wherein the ceramic puck is fabricated by at least one of aluminum oxide (Al₂O₃), aluminum nitride (AIN), titanium oxide (TiO), titanium nitride (TiN), silicon carbide (SiC), and a ceramic material containing rare earth metal.
